# EUROPEAN PATENT APPLICATION

(11) **EP 1 502 970 A1**
(43) Date of publication of application: **02.02.2005**
(21) Application number: 03725665.8
(22) Date of filing: 24.04.2003
(51) Int. Cl.: C23F 4/00

(54) **ZNSE DIFFRACTION TYPE OPTICAL COMPONENT AND METHOD FOR FABRICATING THE SAME**

(30) Priority: 07.05.2002 JP 2002131442
(71) Applicant: SUMITOMO ELECTRIC INDUSTRIES, Ltd, Osaka-shi, Osaka 541-0041 (JP)
(72) Inventor: KURISU, K., Osaka Works Sumitomo Elec. Ind. Ltd., Osaka-shi, Osaka 554-0024 (JP); OKADA, T., Osaka Works Sumitomo Elec. Ind. Ltd., Osaka-shi, Osaka 554-0024 (JP)
(74) Representative: Grünecker, Kinkeldey, Stockmair & Schwanhäusser Anwaltssozietät
(86) International application number: PCT/JP2003/005304
(87) International publication number: WO 2003/095703

(57) **Abstract**

Plasma is generated by an induced magnetic field produced with a coil, and the surface of a ZnSe substrate is etched by the plasma. Employing this method allows the production of a pattern in which the internal angle formed between the sidewall of the pattern and the surface of the ZnSe substrate is equal to or over 75 degrees. This makes it possible to offer a ZnSe diffractive optical element having improved diffraction efficiency and higher performance.

## Description

### Technical Field

The present invention relates generally to a zinc selenide diffractive optical element, and specifically to a zinc selenide diffractive optical element having improved diffraction efficiency. This invention also relates to a method of producing the same.

### Background Art

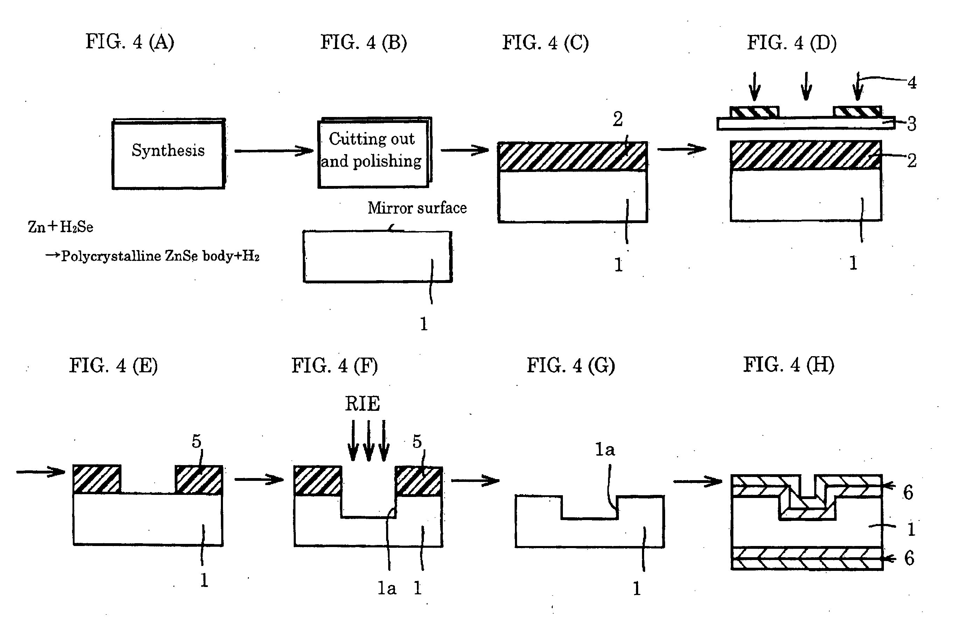

Figure 4 illustrates a conventional method of producing a diffractive optical element (hereinafter referred to as a "DOE") employing a polycrystalline zinc selenide (ZnSe).

In reference to Fig. 4 (A), Zn and H₂Se are used as raw materials in the synthesis of a zinc selenide polycrystalline body. Referring to Fig. 4 (B), a polycrystalline zinc selenide is cut out from the zinc selenide body to create a polycrystalline zinc selenide substrate 1. With reference to Fig. 4 (C), a resist film 2 is formed on the polycrystalline ZnSe substrate 1.

Referring to Fig. 4 (D), a pattern is printed in the resist film 2 by selectively irradiating light 4 using a photomask 3.

In reference to Figs. 4 (D) and 4 (E), the resist film 2 is developed for the formation of a resist pattern 5. In reference to Figs. 4 (F) and 4 (G), a pattern 1a is formed using the resist pattern 5 for reactive ion etching of the polycrystalline ZnSe substrate 1. In Figs: 4 (F) and 4 (G), for convenience in producing drawings, the side walls of the pattern 1a are illustrated as if they were perpendicular to the surface of the polycrystalline ZnSe substrate 1. As described hereinafter, however, the sidewall of the pattern 1a tends not to be angled at 90 degrees such as shown in the figures.

A DOE is obtained by providing antireflection coatings (AR coating) on the polycrystalline ZnSe substrate 1 as shown in Fig. 4 (H).

Unlike conventional optical elements utilizing refraction and reflection, the DOE produced by the aforementioned method utilizes optical diffraction, allowing the DOE to directly control the optical phase thereof. With this special feature, the DOE can be applied to various uses, such as a device having multipoint spectroscopic function.

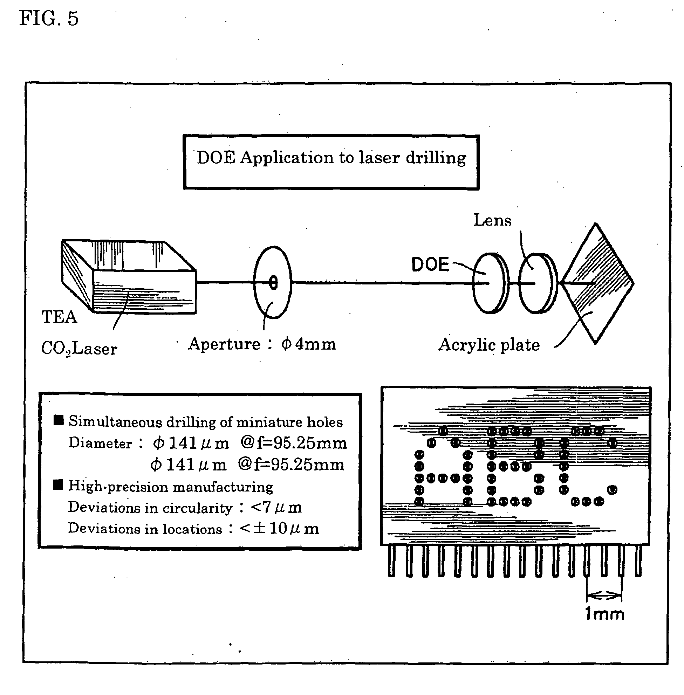

One such application is an optical element for carbon dioxide laser processing as illustrated in Fig. 5. As disclosed in Japanese Patent Laid-Open Nos. 2000-280226 and 2000-280225, a single working laser beam is split to drill a plurality of holes simultaneously, thereby realizing high-speed precision drilling.

With the downsizing of electronic components and devices used for mobile phones, personal computers, and other equipment, higher speed and accuracy are required in drilling. In light of this, the DOE is a promising key device to meet such needs.

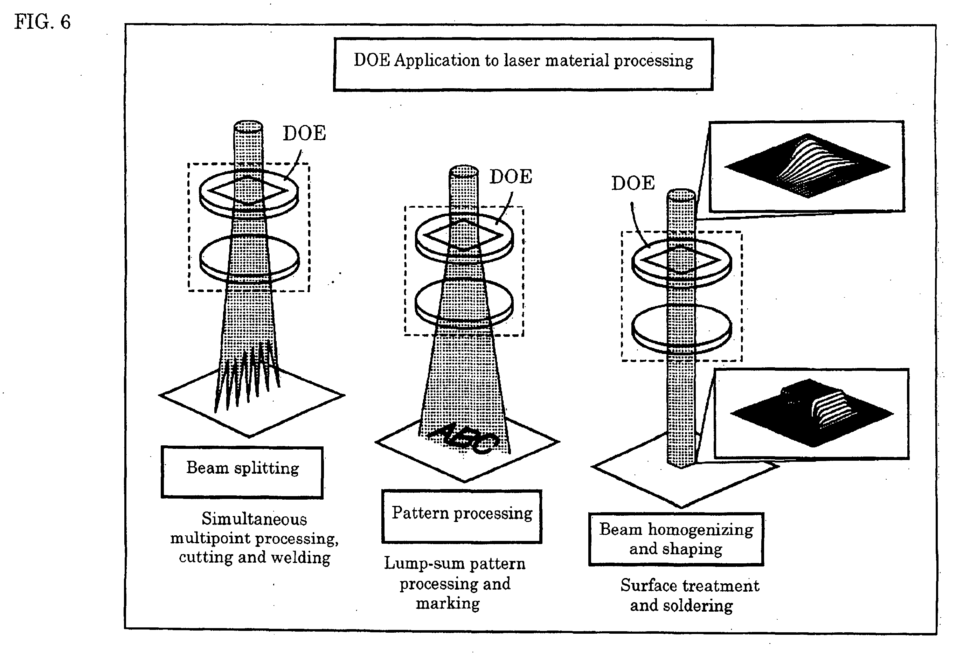

Figure 6 illustrates applications of a DOE to laser material processing. Zinc selenium having high transparency with respect to infrared light is employed as the material of an optical element used for carbon-dioxide laser processing. As for a zinc selenium body having a diameter in the range of 1 to 3 inches and a thickness of several millimeters, which is generally used for an optical element, a polycrystalline material rather than a monocrystalline material is used for cost-related reasons. In particular, zinc selenium polycrystals synthesized through chemical vapor deposition (CVD) and having high purity are often employed.

In any application, the DOE needs to exhibit high diffraction efficiency. It has been recognized that the interior angle formed between the sidewall of the pattern 1a and the surface of the polycrystalline ZnSe substrate 1 as illustrated in Fig. 4 (G) is preferably 90 degrees for the sake of improved diffraction efficiency.

### Disclosure of Invention

In a conventional reactive ion etching process illustrated in Fig. 4 (G), a reactive ion beam etching apparatus with parallel-plate electrodes is employed as shown in Fig. 7. However, this apparatus achieved a limited success: the angle formed between the side wall of the pattern and the surface of the ZnSe substrate is no more than 70 degrees as shown in Fig. 8. This problem will be explained in further detail hereinafter.

The present invention has been achieved in order to solve the aforementioned problem. An object of the invention is to offer a ZnSe diffractive optical element having improved diffraction efficiency by effectively increasing the interior angles formed by the vertical sides of the pattern and the surface of the ZnSe substrate.

Another object of the present invention is to offer a method of producing such a ZnSe diffractive optical element.

A ZnSe diffractive optical element according to this invention includes a ZnSe substrate and a pattern formed on the surface thereof. The side walls of the pattern are angled at or over 75 degrees to the surface of the ZnSe substrate.

In a preferable embodiment of the present invention, the interior angle formed between the sidewall of the pattern and the surface of the ZnSe substrate is in a range from 75 degrees to 85 degrees.

In a method of producing a ZnSe diffractive optical element according to another aspect of the invention, plasma is generated with an induced magnetic field produced by a coil. The surface 'of the ZnSe substrate is subjected to etching with the plasma.

In a preferable embodiment of the present invention, the plasma includes chloride-based gas plasma.

In a more preferable embodiment of this invention, the plasma includes chloride-based gas plasma and inert gas plasma. The inert gas, which is employed for the purpose of improving the sputter effect, is also useful to stabilize the plasma.

In a further preferable embodiment of the present invention, the chloride-based gas includes BCl₃ gas, while the inert gas includes Ar gas.

According to a preferable embodiment of this invention, the etching process is conducted at 0.5 Pa or under.

### Brief Description of the Drawings

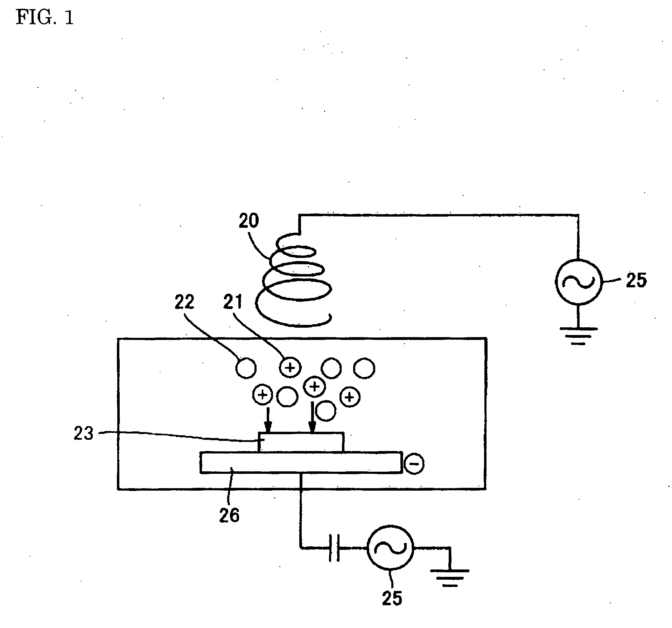

Figure 1 is a conceptual diagram of an inductively-coupled-plasma reactive ion etching (ICP-RIE) apparatus employed for carrying out an embodiment of the present invention.

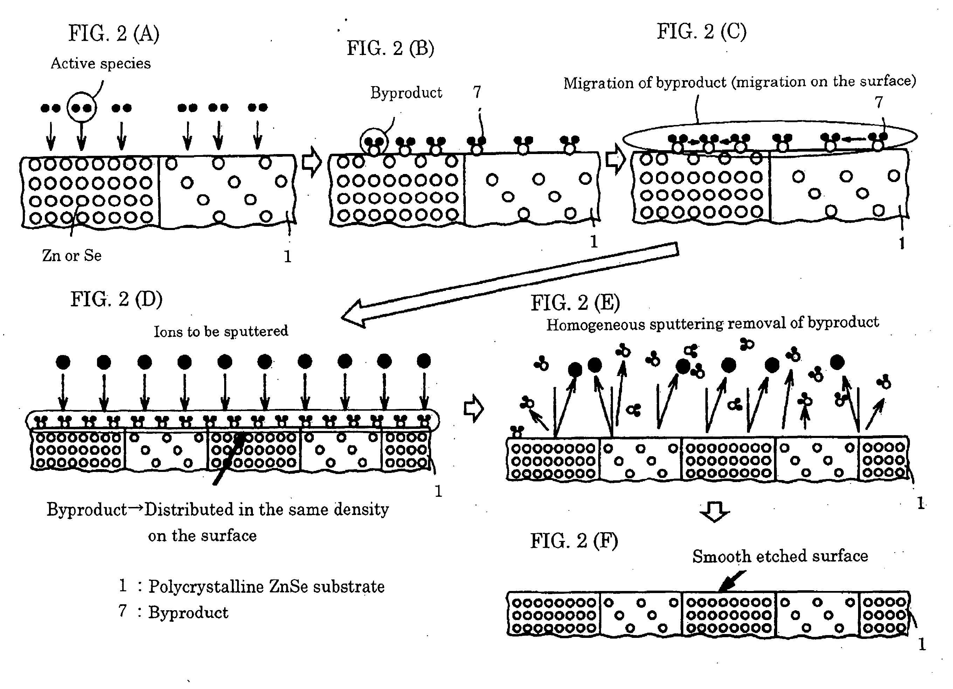

Figure 2 is a conceptual diagram illustrating a mechanism of etching the surface of a ZnSe substrate.

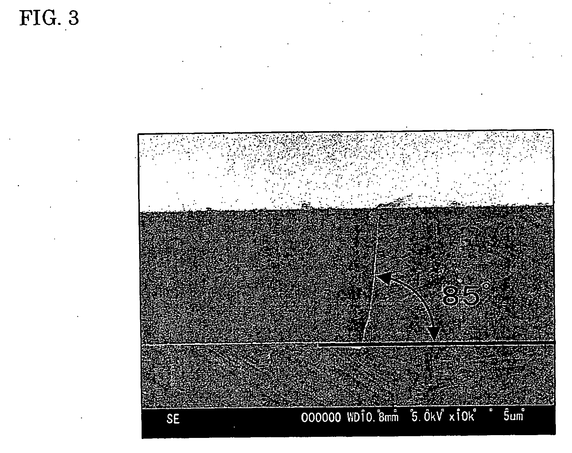

Figure 3 illustrates a scanning electron microscopic (SEM) image of a cross section of a pattern formed on the ZnSe substrate according to the present invention.
Figure 4 shows a process of manufacturing a conventional diffractive optical element wherein a polycrystalline ZnSe is employed.
Figure 5 illustrates an application of a DOE to laser drilling.
Figure 6 shows an application of a DOE to laser material processing.

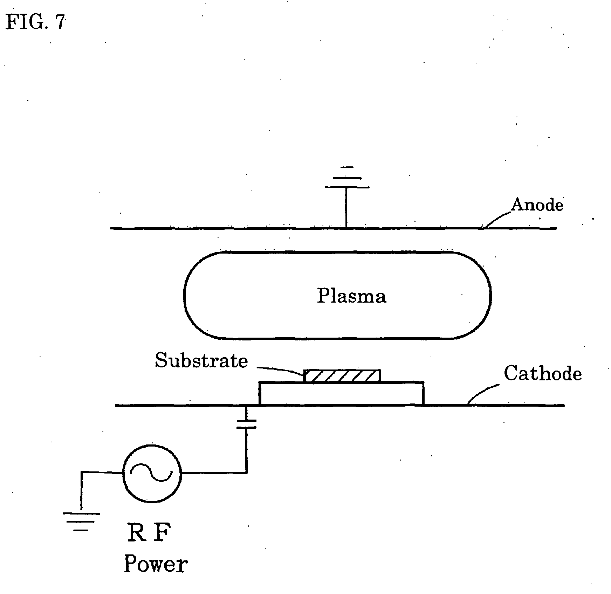

Figure 7 is a conceptual diagram of a conventional reactive ion beam etching apparatus with parallel-plate electrodes.

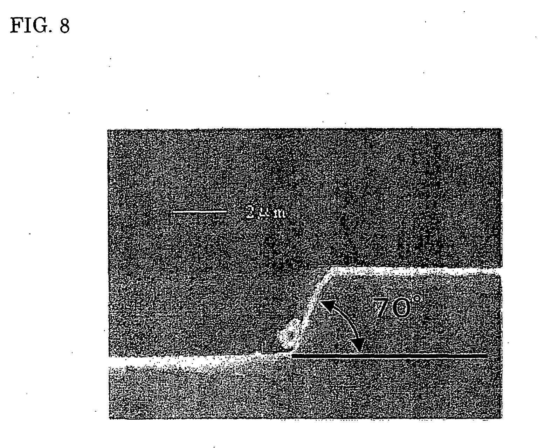

Figure 8 illustrates an SEM image of a cross section of the pattern produced on the ZnSe substrate using the conventional reactive ion beam etching apparatus with parallel-plate electrodes.

### Best Mode for Carrying out the Invention

Preferred embodiments of the present invention are described hereinafter with reference to the accompanying drawings.

Figure 1 illustrates an inductively-coupled-plasma reactive ion etching (ICP-RIE) apparatus related to the method of producing a ZnSe diffractive optical element according to the present invention. A highfrequency power supply 25 is applied both to a coil 20 and a cathode 26. In the inductively-coupled-plasma reactive ion etching apparatus of Fig. 1, the coil 20 is used to create an induced magnetic field, wherein plasma is to be generated. The plasma includes cations 21, together with uncharged particles 22 (hereinafter referred to as "particles 22") represented by BCl₃ molecules and Ar atoms. A type of gas to be employed is a chloride-based gas such as BCl₃.

If a ZnSe substrate is selected as a material to be subjected to etching, a conceivable etching mechanism is such that the active species (Cl or Cl₂) in the chloride-based gas which is in a state of plasma reacts with ZnSe to generate byproducts such as ZnCl₂, Se₂Cl₂, or SeCl₄ on the ZnSe substrate, and the byproducts are subjected to sputtering with cations (e.g., Cl⁺, Cl₂⁺, and BCl⁺) accelerated in an electric field arising in a sheath region. Details of this mechanism are provided hereinafter.

In this embodiment, the plasma can be confined by the induced magnetic field generated by the coil. Thus, it is possible to secure a high density of sputtered ions, which are the cations 21. Even if the density of the chloride-based gas is thinner (in other words, even at a lower pressure), the sputtered ion density achieved in this embodiment is equivalent to the level provided by the conventional etching apparatus with parallel-plates electrodes. When a lower pressure is applied, the number of the particles 22 decreases, thus expanding the mean free path of the cations 21. This decreases the collision between the cations 21 and the particles 22, consequently increasing the verticality of the movement of the cations 21, and enabling the sputtered ions to perpendicularly collide with a ZnSe substrate 23.

When a conventional reactive ion beam etching apparatus with parallel-plate electrodes is used, the lowest pressure ensuring stable plasma discharge is approximately 0.8 Pa and the density of the generated plasma ranges from 10⁸ cm⁻³ to 10⁹ cm⁻³. Under this condition, the cations 21 accounted for roughly 0.01% of the total number of particles. Before reaching the ZnSe substrate, many of the cations 21 tended to collide with other particles, which resulted in their curbed movement and failure in their achieving perpendicularity. Consequently, such angle of the sidewall of the pattern as obtainable was limited to approximately 70 degrees at maximum. Such degradation in the perpendicularity of the etched sidewall resulted in an error of the cell width accuracy relative to the designed values. For instance, in the case of a beam-splitting DOE designed to split a beam into more than 10 beams, the overall signal intensity tends to be lowered, which has resulted in the drawback that zeroth-order light becomes prominent.

As provided heretofore, the conventional reactive ion beam etching apparatus with parallel-plate electrodes is not used; and an inductively-coupled-plasma reactive ion etching apparatus, which is capable of etching at a lower pressure, is used for etching according to the present invention. In the inductively-coupled-plasma reaction ion etching, the generation of plasma having a high density of approximately 10¹¹cm⁻³ is possible since the coil generates an induced magnetic field which confines the plasma. Such a high density allows a larger proportion of ions to contribute to the etching process even at a lower pressure and achieve perpendicularity, as compared with the case of using a reactive ion beam etching apparatus with parallel plate electrodes. Furthermore, even with a pressure of 0.5 Pa or under, stable discharge is possible, resulting in a superior level of ion perpendicularity.

With reference to Figs. 2 (A) and 2 (B), etching of the polycrystalline ZnSe substrate 1 using BCl₃ generates byproducts 7 such as ZnCl₂, Se₂Cl₂, and SeCl₄ having low vapor pressure.

Referring to Figs. 2 (B) and 2 (C), the byproducts 7 migrate to spread homogeneously on the surface of the polycrystalline ZnSe substrate 1.

As illustrated in Figs. 2 (D) and 2 (E), sputtered ions (cations) etch to remove the byproducts 7, and subsequently etch the polycrystalline ZnSe substrate 1 as shown in Fig. 2 (F).

The process illustrated in Figs. 2 (A), (B), (C), (D) and (E) is repeated to conduct the etching of the surface of the polycrystalline ZnSe substrate 1. As clarified by the aforementioned mechanism, a very smooth etched surface that has been less affected by the crystalline direction of the polycrystalline ZnSe was obtained according to the present invention.

In this case, employing inductively-coupled-plasma reactive ion etching allows the generation of high-density plasma of approximately 10¹¹ cm⁻³, thus enabling the pressure to be reduced to 0.5 Pa or under. Even in such a low pressure as 0.5 Pa or under, a larger proportion of ions contribute to the etching process and higher ion perpendicularity is achieved as compared with the cases employing reactive ion beam etching with parallel plates electrodes.

Figure 3 shows a cross section of the pattern obtained on the ZnSe substrate through the aforementioned process. According to this process, a smooth etched surface was achieved, and the interior angle formed between the sidewall of the pattern and the surface of the ZnSe substrate was in a range from 75 degrees to 85 degrees. The ZnSe diffractive optical element obtained through this process exhibited improved diffraction efficiency and excellent performance.

Although the embodiments disclosed herein employ a chloride-based gas, the present invention should not be considered as excluding other embodiments. Plasma may be generated with the combination of a chloride-based gas and an inert gas. In this case, it is preferable that BCl₃ accounts for one-third of the total gas, the remaining two-thirds being an inert gas. Such an inert gas is helpful to stabilize discharge of the chloride-based gas.

Aside from BCl₃, HCl or Cl₂ is also employed as the chloride based gas. However, BCl₃ is most preferable as it can generate heavy ions which are considered capable of creating a greater sputter effect. As for the inert gas, Ar gas, which is relatively inexpensive and capable of generating heavy ions, has produced a favorable result.

### Industrial Applicability

As provided heretofore, according to the present invention, high density plasma can be obtained since inductively-coupled-plasma reactive ion etching is used for producing plasma. Therefore, as compared with the cases of reactive ion beam etching with parallel plate electrodes, a larger proportion of ions contribute to etching even at a low pressure, and a higher level of ion perpendicularity is achieved. Since such inductively coupled plasma reactive ion etching is employed for etching a ZnSe substrate, in a pattern thereby produced a larger interior angle can be formed between the sidewall thereof and the surface of the ZnSe substrate. Consequently, a ZnSe diffractive optical element having improved diffraction efficiency and capable of higher performance can be obtained.

## Claims

1. A ZnSe diffractive optical element, comprising:
a ZnSe substrate; and
a pattern formed on a surface of the ZnSe substrate and which has an
internal angle formed between a sidewall of the pattern and the surface of the ZnSe substrate;
wherein the internal angle is equal to or larger than 75 degrees.

2. A ZnSe diffractive optical element according to claim 1, wherein the interior angle between the sidewall of the pattern and the surface of the ZnSe substrate is in a range from 75 degrees to 85 degrees.

3. A method of manufacturing a ZnSe diffractive optical element, comprising:
a process of generating plasma with an induced magnetic field produced by a coil; and
a process of etching the surface of a ZnSe substrate by the plasma.

4. A method of manufacturing a ZnSe diffractive optical element according to claim 3, wherein the plasma includes chloride-based gas plasma.

5. A method of manufacturing a ZnSe diffractive optical element according to claim 3, wherein the plasma includes chloride-based gas plasma and inert gas plasma.

6. A method of manufacturing a ZnSe diffractive optical element according to Claim 5, the chloride-based gas including BCl₃ gas and the inert gas including Ar gas.

7. A method of manufacturing a ZnSe diffractive optical element according to Claim 3, the etching being conducted at or under 0.5 Pa.

8. A ZnSe diffractive optical element produced by a method defined in any one of claims 3, 4, 5, 6 and 7.
